(19) Europäisches Patentamt / European Patent Office / Office européen des brevets

(11) **EP 2 068 326 B1**

(12) **EUROPEAN PATENT SPECIFICATION**

(45) Date of publication and mention
of the grant of the patent:
**26.05.2010 Bulletin 2010/21**

(51) Int Cl.:
**G21K 1/06** *(2006.01)*     **G03F 7/20** *(2006.01)*

(21) Application number: **08020076.9**

(22) Date of filing: **18.11.2008**

(54) **Exposure mirror and exposure apparatus having same**

Belichtungsspiegel und damit versehene Belichtungsvorrichtung

Miroir d'exposition et appareil d'exposition utilisant celui-ci

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **07.12.2007 JP 2007316802**

(43) Date of publication of application:
**10.06.2009 Bulletin 2009/24**

(73) Proprietor: **Canon Kabushiki Kaisha**
**Tokyo (JP)**

(72) Inventors:
- **Kotoku, Masashi**
  **Tokyo (JP)**
- **Ito, Jun**
  **Tokyo (JP)**
- **Masaki, Fumitaro**
  **Tokyo (JP)**
- **Miyake, Akira**
  **Tokyo (JP)**
- **Matsumoto, Seiken**
  **Tokyo (JP)**

(74) Representative: **Weser, Thilo**
**Weser & Kollegen**
**Patentanwälte**
**Radeckestrasse 43**
**81245 München (DE)**

(56) References cited:
**EP-A- 1 367 605**     **EP-A- 1 630 856**
**US-A1- 2005 031 071**     **US-A1- 2005 270 648**
**US-A1- 2007 171 327**

- **T.KUHLMANN ET AL: "Design and fabrication of broadband EUV multilayer mirrors" PROCEEDINGS OF SPIE, [Online] vol. 4688, 2002, pages 509-515, XP002521593 Retrieved from the Internet: URL:http://spiedigitallibrary.aip.org/geta bs/servlet/GetabsServlet? prog=normal&id=PS ISDG0046880000010005090000001&idtype=cvips & gifs=Yes&bproc=volrange&scode=4600%20-%2 04 699> [retrieved on 2009-03-27]**

**Description**

BACKGROUND OF THE INVENTION

Field of the Invention

The present invention relates to a mirror used in an exposure apparatus, and more specifically, it relates to a mirror for the extreme ultraviolet (EUV) region at wavelengths of about 10 to 15 nm.

Description of the Related Art

Hitherto, reduction projection exposure using ultraviolet light has been performed as a lithography method for manufacturing fine semiconductor elements such as semiconductor memories and logic circuits.

The minimum critical dimension that can be transferred by the reduction projection exposure is proportional to the wavelength of exposure light used for transfer, and is inversely proportional to the numerical aperture of the projection optical system. Therefore, along with increased fineness of circuit patterns, the wavelength of exposure light has been shortened from mercury lamp i-line (365 nm) through KrF excimer laser (248 nm) to ArF excimer laser (193 nm).

However, the fineness of semiconductor elements is rapidly increasing, and the lithography using ultraviolet light has limitations. Therefore, in order to efficiently transfer very fine circuit patterns below 0.1 $\mu$m, reduction projection exposure apparatuses (EUV exposure apparatuses) using EUV light having wavelengths about 10 to 15 nm shorter than the wavelengths of ultraviolet light are being developed.

Mirrors constituting an EUV exposure apparatus include multilayer film mirrors and oblique incidence total reflection mirrors. In the EUV region, the real part of the refractive index is slightly smaller than one. Therefore, when EUV light is obliquely incident at a very small angle to the surface, total reflection occurs. Normally, in the case of oblique incidence at an angle of not more than several degrees to the surface, a high reflectance of several tens of percent or more can be obtained, but the optical design freedom is low.

Therefore, a multilayer film mirror in which two kinds of materials having different optical constants (refractive indices) are alternately deposited in layers is used as an EUV light mirror having high optical design freedom. In the case of a multilayer film mirror, a desired reflectance can be obtained at an incidence angle near the normal incidence.

A multilayer film mirror for EUV light is formed by alternately depositing molybdenum and silicon in layers on the surface of a glass substrate that is polished so as to have a precise surface shape. For example, the thickness of each molybdenum layer is about 2 nm, the thickness of each silicon layer is about 5 nm, and the number of pairs of layers is about 20. The sum of the thicknesses of layers of two kinds of materials is called a film period. In the above example, the film period is 2 nm + 5 nm = 7 nm.

When EUV light is incident on such a molybdenum-silicon multilayer film mirror, EUV light with a particular wavelength is reflected.

If we denote the incidence angle by $\theta$, the wavelength of EUV light by $\lambda$, and the film period by d, only EUV light having a narrow bandwidth around the wavelength $\lambda$ that approximately satisfies the Bragg equation:

$$2 \times d \times \cos \theta = \lambda \qquad (1)$$

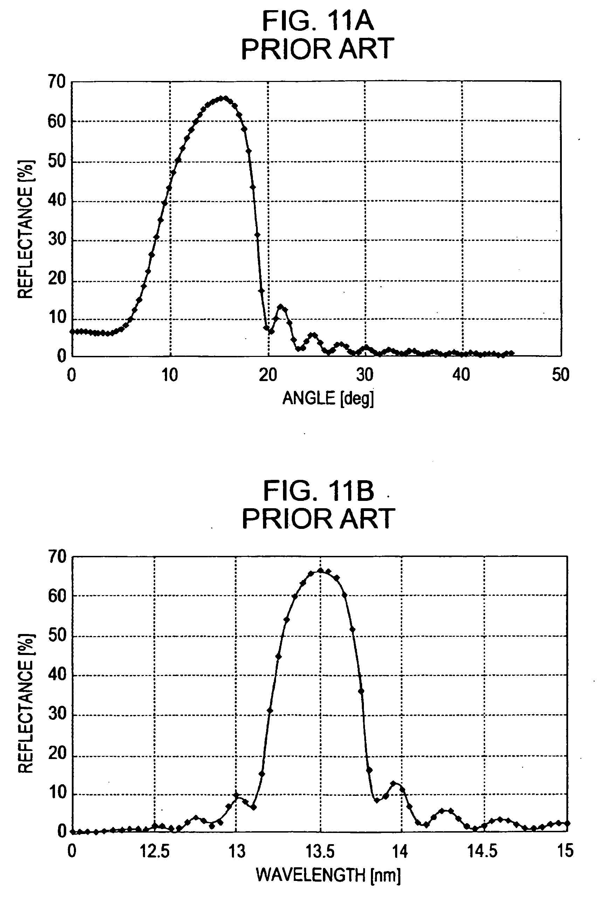

is reflected efficiently. In this case, the bandwidth is about 0.6 to 1 nm. FIGS. 11A and 11B show the reflectance characteristic of a multilayer film mirror having an incidence angle of 15 degrees and a film period of 7.2 nm.

In an actual exposure apparatus, the angle of light incident on the same place on a mirror is not constant but inevitably has a certain range of angle distribution. However, as is clear from the above Bragg equation, a multilayer film mirror designed to have a constant film period (periodic structure) has high reflectance only for the light at a certain incidence angle. If the intensity of light reflected by a multilayer film mirror depends on the incidence angle, irregularity in pupil transmittance distribution occurs, and the imaging performance deteriorates.

To solve this problem, in Japanese Patent Laid-Open No. 2007-134464 (corresponding to US 2007/0171327 A1), a multilayer film mirror designed to have non-constant film period (aperiodic structure) is used.

Said multilayer film mirror indeed comprises an aperiodic Mo/Si lamination structure, which is deposited onto the mirror's substrate, and a periodic Mo/Si lamination structure, which is deposited a top the aperiodic one.

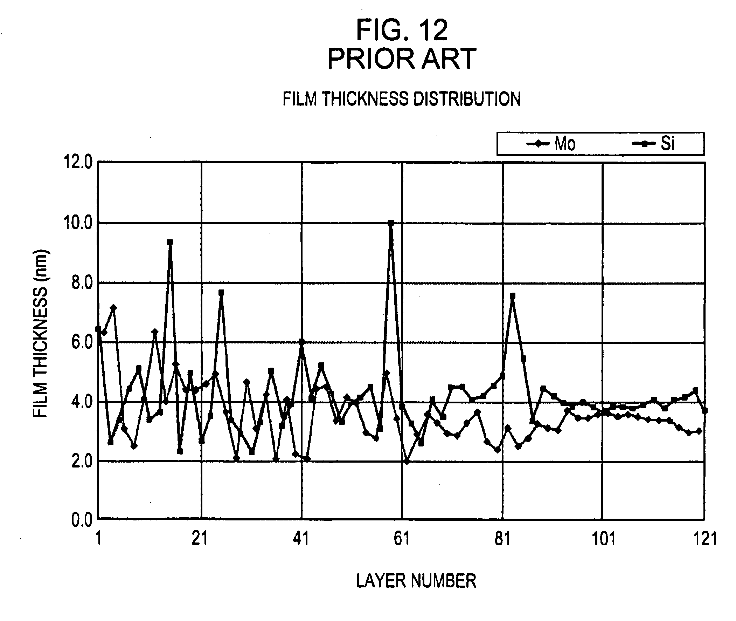

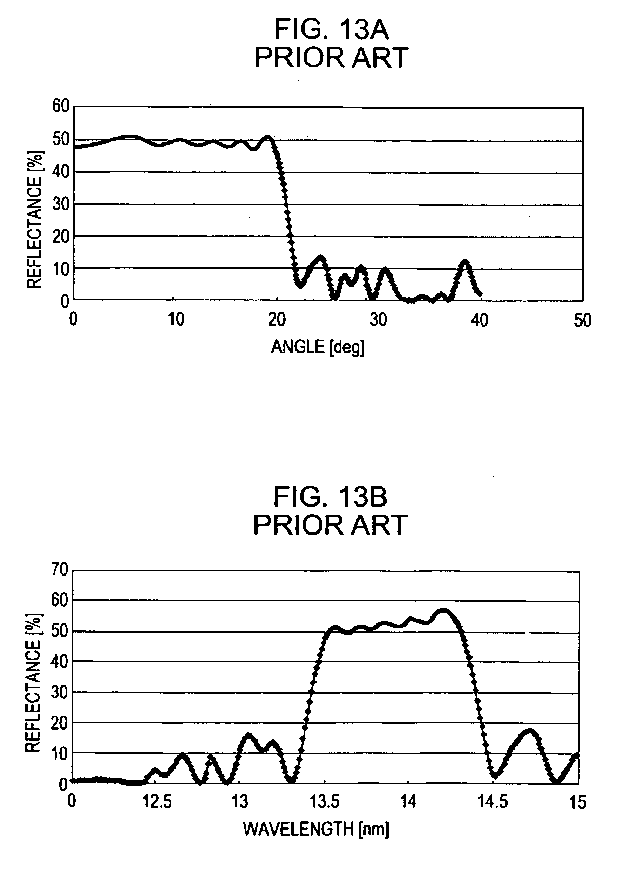

Document US 2005/0270648 A1 also discloses a multilayered film with a laminated structure mode of a stock of non-periodic and periodic films. For example, a multilayer film mirror having an aperiodic structure made according to the designed values of film thickness shown in FIG. 12 has a uniform reflection characteristic over a wide range of incidence angle as shown in FIGS. 13A.

In general, a multilayer film mirror is designed to have a gradient of film thickness in the radial direction of the surface. If the film thickness of a made-up mirror deviates from the designed value, aberrations and flare occur and deteriorate the performance of the exposure apparatus. Of the error between a designed value of film thickness and the film thickness of a made-up mirror, the power component can be corrected in the projection optical system but the other components conventionally cannot be corrected.

If we denote the number of mirrors constituting a projection optical system by n and the wavelength of EUV light by λ, an allowable shape error σ (rms value) is given by the Marechal equation:

$$\sigma \;=\; \lambda \;/\; (28 \times \sqrt{n}) \qquad\qquad (2)$$

For example, in the case of a system having six mirrors and a wavelength of 13.5 nm, the allowable shape error σ = 0.2 nm. The shape error includes components for the substrate shape and the film shape. Of 0.2 nm, when the error allowed for the film shape is 0.15 nm and this is distributed between the deposition and the measurement of film shape, the error allowed for the measurement of film shape is about 0.1 nm. Since the number of film layers of a multilayer film is about 50, the measurement accuracy required for a layer is 0.002 nm = 0.015%.

As shown in the Bragg equation (1) and FIG. 11B, the peak wavelength of the reflectance of a multilayer film mirror having a periodic structure depends on the film thickness. Therefore, by measuring the peak wavelength of each position in the mirror surface with a high degree of accuracy, the film thickness distribution in the mirror surface can be measured.

However, the reflectance characteristic of a multilayer film mirror having an aperiodic structure does not have a peak as shown in FIG. 13B. Therefore, the film thickness distribution cannot be measured using the peak wavelength of reflectance. In addition, since the X-ray diffraction uses the effect of interference, it cannot be applied to a multilayer film mirror having an aperiodic structure.

Ellipsometry can be used for inspecting the film thickness of a multilayer film mirror having an aperiodic structure. During the deposition of a multilayer film mirror, evaluation is performed by ellipsometry every time a layer is deposited, and thereby the whole film thickness is evaluated. However, the accuracy of ellipsometry is about ±0.15%, for example, in the case of measurement of molybdenum layers, and does not satisfy the measurement accuracy required for a multilayer film mirror with which an exposure apparatus is equipped, for example, 0.015%.

As described above, there has not been a method for accurately evaluating the film thickness of a multilayer film mirror having an aperiodic structure.

SUMMARY OF THE INVENTION

The present invention provides an exposure mirror that is a multilayer film mirror having an aperiodic structure and that has an accurately-controllable film thickness distribution.

The present invention in its first aspect provides an exposure mirror as specified in claims 1 to 14.

The present invention in its second aspect provides a method for manufacturing an exposure mirror as specified in claims 15 to 16.

A multilayer film having an "aperiodic" thickness means a multilayer film having a non-constant film period as described above. A multilayer film having a "periodic" thickness means a multilayer film having a constant film period.

The exposure mirror of the present invention has an accurately-controllable film thickness distribution.

Further features of the present invention will become apparent from the following description of exemplary embodiments with reference to the attached drawings.

BRIEF DESCRIPTION OF THE DRAWINGS

FIG. 1 is a schematic view showing the structure of an EUV exposure apparatus.

FIGS. 2A and 2B are respectively a front view and a schematic sectional view of an exposure mirror of a first embodiment.

FIG. 3 shows an example of an exposure mirror in which evaluation regions are each divided in the radial direction.

FIG. 4 is a schematic view showing the structure of a sputtering deposition system.

FIG. 5 is a flowchart of a deposition process of the first embodiment.

FIGS. 6A and 6B are respectively a front view and a schematic sectional view of an exposure mirror of a second embodiment.

FIG. 7 is a flowchart of a deposition process of the second embodiment.

FIGS. 8A and 8B are respectively a front view and a schematic sectional view of an exposure mirror of a third embodiment.

FIGS. 9A and 9B are respectively a front view and a schematic sectional view of an exposure mirror of a fourth embodiment.

FIGS. 10A and 10B are respectively a front view and a schematic sectional view of an exposure mirror of a fifth embodiment.

FIGS. 11A and 11B respectively show the angle reflectance characteristic and the wavelength reflectance characteristic of a periodic multilayer film mirror.

FIG. 12 shows the film thickness of each layer of an aperiodic multilayer film mirror.

FIGS. 13A and 13B respectively show the angle reflectance characteristic and the wavelength reflectance characteristic of an aperiodic multilayer film mirror.

FIG. 14 is a flowchart for illustrating a device manufacturing method.

FIG. 15 is a detailed flowchart of the wafer process of FIG. 14.

DESCRIPTION OF THE EMBODIMENTS

The embodiments of the exposure mirror of the present invention will now be described with reference to the drawings.

First, an EUV exposure apparatus to which the exposure mirror of the present invention is applied will be outlined.

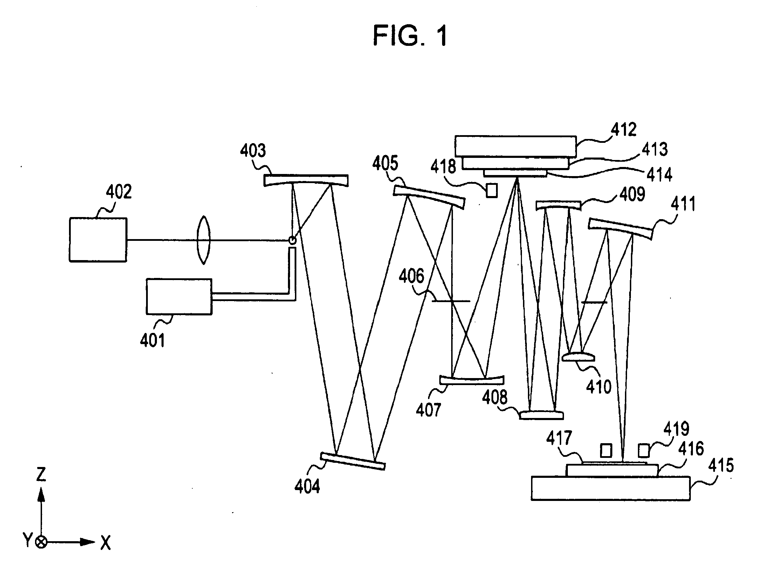

The EUV exposure apparatus is composed mainly of a light source, an illumination optical system, a projection optical system, a reticle stage, and a wafer stage. FIG. 1 is a schematic view of the EUV exposure apparatus according to a first embodiment of the present invention.

For example, a laser plasma light source is used as the EUV light source. A target supply unit 401 supplies a target material into a vacuum container. An intense pulse laser light source 402 irradiates the target material with laser light to generate high-temperature plasma, which emits EUV light having a wavelength of about 13.5 nm. Target materials include a metal thin film, an inert gas, and a liquid droplet. The target material is supplied into the vacuum container, for example, by means of a gas jet. To increase the average intensity of the EUV light emitted from the target, the frequency of the pulse laser light source 402 may be high, and is normally about several kHz.

The illumination optical system includes a plurality of multilayer film mirrors 403, 405, and 407 and an optical integrator 404. The first mirror 403 collects EUV light substantially isotropically emitted from the laser plasma. The optical integrator 404 illuminates a mask uniformly at a predetermined numerical aperture. An aperture 406 is provided at a position in the illumination optical system conjugate to a reticle. The aperture 406 limits the illuminated region on the reticle surface to an arc shape.

The projection optical system is composed of a plurality of multilayer film mirrors 408, 409, 410, and 411. A small number of mirrors improve the use efficiency of EUV light but makes aberration correction difficult. The projection optical system is composed of four mirrors in this embodiment, but it may alternatively be composed of six or eight mirrors, for example. The mirrors have a convex or concave spherical or aspherical reflecting surface. The numerical aperture NA of the projection optical system is about 0.2 to 0.3.

The reticle stage 412 and the wafer stage 415 scan in synchronization with each other in the velocity ratio proportional to the reduction ratio. Let us denote the scanning direction in the plane of the reticle 414 or a wafer 417 by X, the direction perpendicular thereto in the plane of the reticle 414 or the wafer 417 by Y, and the direction perpendicular to the plane of the reticle 414 or the wafer 417 by Z.

The reticle 414 is held by a reticle chuck 413 on the reticle stage 412. The reticle stage 412 can move in the X direction at high speed. The reticle stage 412 can finely move in the X direction, Y direction, Z direction, and rotational direction around each axis, and can thereby position the reticle 414. The position and orientation of the reticle stage 412 are measured by a laser interferometer 418. Based on the results, the position and orientation are controlled.

The wafer 417 is held on the wafer stage 415 by a wafer chuck 416. Like the reticle stage 412, the wafer stage 415 can move in the X direction at high speed. The wafer stage 415 can finely move in the X direction, Y direction, Z direction, and rotational direction around each axis, and can thereby position the wafer 417. The position and orientation of the wafer stage 415 are measured by a laser interferometer 419. Based on the results, the position and orientation are controlled.

After the completion of a scan exposure on the wafer 417, the wafer stage 415 step-moves in the X and Y directions to move to the scan exposure start position of the next shot. The reticle stage 412 and the wafer stage 415 again synchronously scan in the X direction in the velocity ratio proportional to the reduction ratio of the projection optical system.

In this way, the reticle 414 and the wafer 417 are repeatedly synchronously scanned with a reduced image of a pattern formed on the reticle 414 projected on the wafer 417 (step and scan). In this way, the pattern of the reticle 414 is transferred onto the whole surface of the wafer 417.

The exposure mirror of the present invention is used as each mirror constituting an illumination optical system and a projection optical system of such an EUV exposure apparatus. The exposure mirror of the present invention may in addition (or alternatively) be used as an EUV light mirror for other purposes.

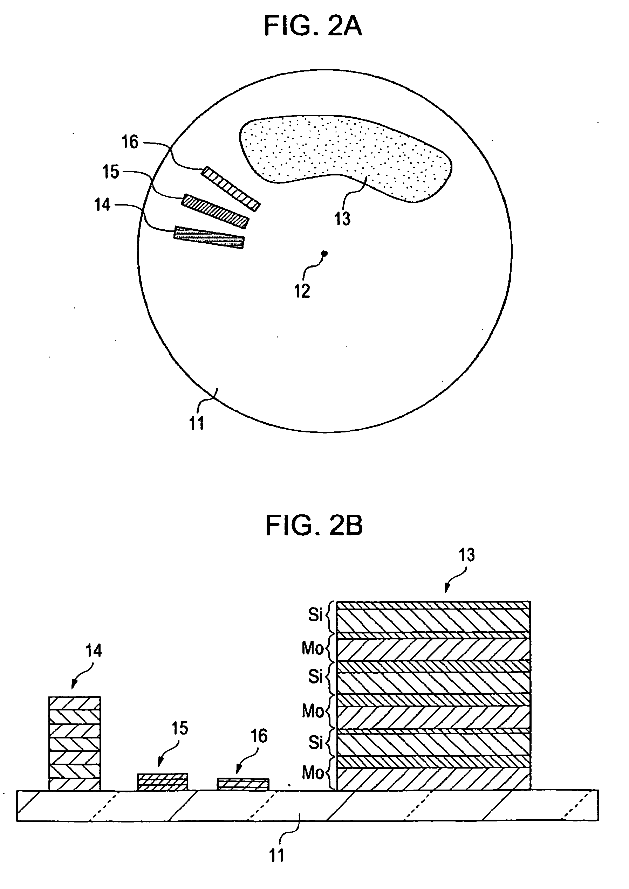

Next, with reference to FIGS. 2A and 2B, the specific structure of the exposure mirror of this embodiment will be described. FIG. 2A is a front view of the exposure mirror of this embodiment, and FIG. 2B is a schematic sectional view thereof.

In FIGS. 2A and 2B, reference numeral 11 denotes a substrate, reference numeral 12 denotes the rotational center of the substrate, reference numeral 13 denotes an effective region, reference numeral 14 denotes a first evaluation region (first region), reference numeral 15 denotes a second evaluation region (second region), and reference numeral 16 denotes a third evaluation region (third region).

The substrate 11 is formed of a material that is rigid and hard and that has a low coefficient of thermal expansion, for example, low expansion glass or silicon carbide. The substrate 11 is formed by grinding and polishing such a material and thereby creating a predetermined reflecting surface shape that is rotationally symmetric around the rotational center 12.

On top of the polished substrate 11, molybdenum (first material) layers and silicon (second material) layers are alternately deposited as reflective layers. For example, a multilayer film capable of efficiently reflecting light of 13.5 nm at a wide incident angle of 5° to 20° has 60 pairs of layers, the thickness of each layer being different (aperiodic multilayer film). The effective region 13 includes this aperiodic multilayer film. The term "effective region" means a region irradiated with exposure light when the mirror is placed, for example, in an exposure apparatus. The thicknesses of the molybdenum (first material) layers are (in order from the substrate 11) M1, M2, M3, ..., M60 [nm]. The thicknesses of the silicon (second material) layers are (in order from the substrate 11) S1, S2, S3, ..., S60 [nm].

The first evaluation region 14, the second evaluation region 15, and the third evaluation region 16 are regions for inspecting and evaluating the effective region 13, and they are formed in a region different from the effective region 13 on the substrate 11. The first evaluation region 14 is a periodic multilayer film in which molybdenum layers 2 [nm] thick and silicon layers 5 [nm] thick are alternately deposited. The second evaluation region 15 is a monolayer film of molybdenum. The third evaluation region 16 is a monolayer film of silicon. The film thickness of the second evaluation region 15 is equal to the difference between the total film thickness of the molybdenum layers constituting the aperiodic multilayer film of the effective region 13 and the total film thickness of the molybdenum layers constituting the periodic multilayer film of the first evaluation region 14. The film thickness of the third evaluation region 16 is equal to the difference between the total film thickness of the silicon layers constituting the aperiodic multilayer film of the effective region 13 and the total film thickness of the silicon layers constituting the periodic multilayer film of the first evaluation region 14. Although the thickness of the first material layers (molybdenum layers) in the first evaluation region 14 is 2 [nm] in this embodiment, the thickness of the first material layers is not limited to 2 [nm] in the present invention. For example, the thickness of the first material layers may be the minimum value of the thicknesses of the plurality of first material layers formed in the effective region 13, or it may be the average of the thicknesses of the plurality of first material layers formed in the effective region 13. Alternatively, the thickness of the first material layers may be a predetermined thickness between the minimum value and the maximum value of the thicknesses of the plurality of first material layers formed in the effective region 13, a thickness smaller than or equal to the minimum value, or a thickness larger than or equal to the maximum value. When the thickness of the first material layers is the minimum value, a below-described deposition process is simple. When the thickness of the first material layers is the average, the total thickness of the first material layers in the first evaluation region 14 is equal to the total thickness of the first material layers in the effective region 13, and therefore the thickness of the effective region 13 can be accurately predicted from the thickness of the first evaluation region 14. The same goes for the thickness of the second material layer (silicon layer) in the first evaluation region 14.

Due to the characteristic of the sputtering deposition system, the supply of the material to be deposited as a thin film is stable for a short time and therefore the film thickness is approximately the same in the circumferential direction, but is unstable for a long time and therefore, in the radial direction, a drift can occur in the amount of deviation of the film thickness from the designed value.

Therefore, to cover the effective region 13 in the radial direction, the first evaluation region 14, the second evaluation region 15, and the third evaluation region 16 are provided so as to extend in the radial direction from the rotational center 12 of the substrate toward the outer circumference.

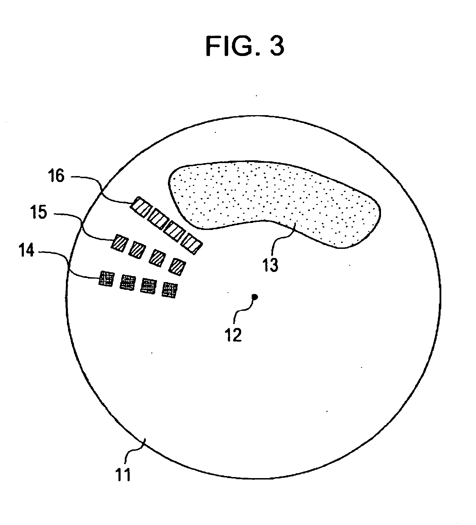

The shape of the evaluation regions 14, 15, and 16 is not limited to a continuous strip shape such as that shown in FIG. 2A but may also be a divided strip shape such as that shown in FIG. 3 as long as the film thickness distribution in the radial direction can be known. That is, the evaluation regions 14, 15, and 16 only have to have such a size that the film thickness distribution of the effective region 13 in the radial direction can be evaluated.

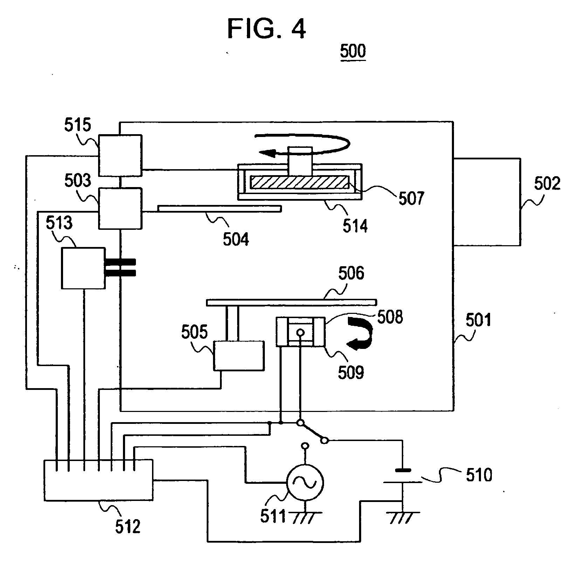

Next, a sputtering deposition system for depositing the multilayer films of the exposure mirror of this embodiment will be described. FIG. 4 is a block diagram of the sputtering deposition system 500.

The deposition system 500 is composed of a vacuum chamber 501, a vacuum pump 502, a film thickness control mask 504, a shutter 506, a rotation mechanism 507, a region selection mask 514, and a below-described control system.

The vacuum chamber 501 is maintained in a vacuum or depressurized environment by the vacuum pump 502 during deposition, and houses each component. The control system includes a film-thickness-control-mask motion control unit 503, a shutter control unit 505, a DC power source 510, an RF power source 511, an argon gas introduction control unit 513, and a region-selection-mask motion control unit 515, which are connected to a control computer 512 and controlled thereby.

In addition to a boron-doped polycrystalline silicon target 508 and a molybdenum target 509 each having a diameter of four inches, ruthenium and boron carbide targets (not shown) are attached. By rotating the targets, each material can be switched, and each material can be deposited on a substrate. The materials of the targets may be changed.

In the rotation mechanism 507 is placed a glass substrate that has a diameter of 500 mm and that is polished so as to have a precise surface shape. During deposition, the substrate is rotated. The shutter 506 and the film thickness control mask 504 are located between the substrate and the targets. The shutter 506 is opened and closed by the shutter control unit 505. The film thickness control mask 504 is moved by the film-thickness-control-mask motion control unit 503 to control the film thickness distribution on the substrate. The region selection mask 514 is located between the substrate and the film thickness control mask 504. The region selection mask 514 is opened and closed by the region-selection-mask motion control unit 515 to limit the depositing region on the substrate. During deposition, argon gas is introduced as process gas from the argon gas introduction control unit 513 at a rate of 30 sccm. With respect to the power applied to the targets, the DC power source 510 maintains a predetermined power, and the RF power source 511 supplies a high frequency (RF) power of 13.56 MHz and 150 W. The control computer 512 controls with time the film thickness of each layer.

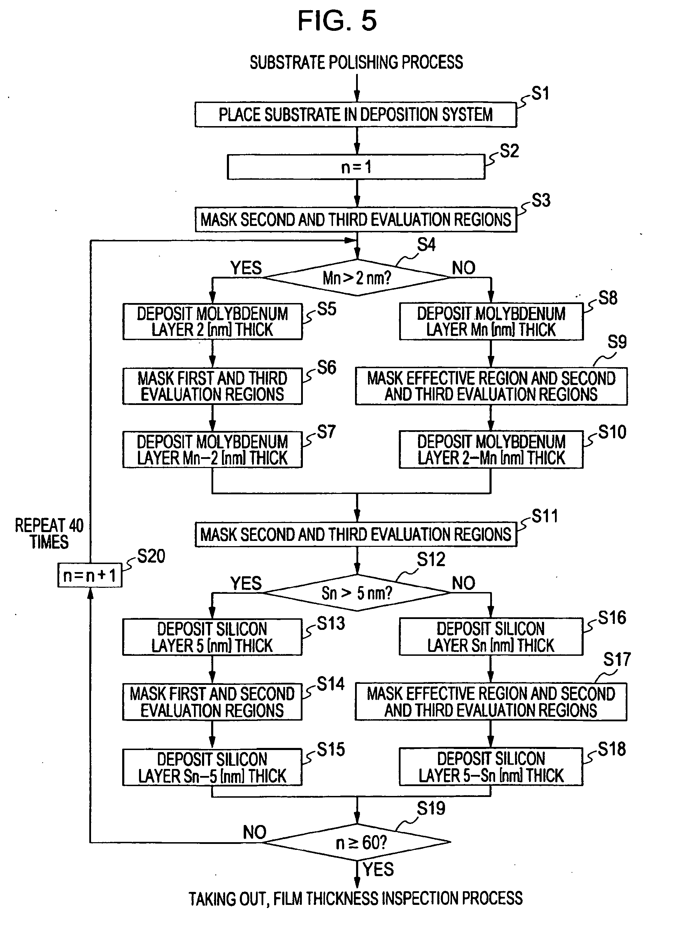

Next, the multilayer film deposition process of the exposure mirror of this embodiment will be described with reference to the flowchart shown in FIG. 5.

In step S1, a polished substrate 11 is placed in the rotation mechanism 507 of the sputtering deposition system 500. In step S2, the control computer 512 substitutes 1 for the layer pair number n showing which pair of layers the present molybdenum or silicon layer belongs to. In step S3, the control computer 512 masks the second evaluation region 15 and the third evaluation region 16 with the region selection mask 514. Next, in step S4, the control computer 512 determines whether the designed thickness $M_n$ [nm] of the molybdenum layer in the nth pair of layers is larger than 2 [nm].

If $M_n > 2$ [nm] in step S4, then in step S5, a molybdenum layer 2 [nm] thick is deposited in each of the effective region 13 and the first evaluation region 14 at the same time. Next, in step S6, the first evaluation region 14 and the third evaluation region 16 are masked, and in step S7, a molybdenum layer $M_n-2$ [nm] thick is deposited in each of the effective region 13 and the second evaluation region 15 at the same time.

If $M_n \leq 2$ [nm] in step S4, then in step S8, a molybdenum layer $M_n$ [nm] thick is deposited in each of the effective region 13 and the first evaluation region 14 at the same time. Next, in step S9, the effective region 13, the second evaluation region 15, and the third evaluation region 16 are masked, and in step S10, a molybdenum layer $2-M_n$ [nm] thick is deposited in the first evaluation region 14.

After step S7 or step S10, in step S11, the second evaluation region 15 and the third evaluation region 16 are masked. In step S12, the control computer 512 determines whether the designed thickness $S_n$ [nm] of the silicon layer in the nth pair of layers is larger than 5 [nm].

If $S_n > 5$ [nm] in step S12, then in step S13, a silicon layer 5 [nm] thick is deposited in each of the effective region 13 and the first evaluation region 14 at the same time. Next, in step S14, the first evaluation region 14 and the second evaluation region 15 are masked, and in step S15, a silicon layer $S_n-5$ [nm] thick is deposited in each of the effective region 13 and the third evaluation region 16 at the same time.

If $S_n \leq 5$ [nm] in step S12, then in step S16, a silicon layer $S_n$ [nm] thick is deposited in each of the effective region 13 and the first evaluation region 14. Next, in step S17, the effective region 13, the second evaluation region 15, and the third evaluation region 16 are masked, and in step S18, a silicon layer $5-S_n$ [nm] thick is deposited in the first evaluation region 14.

After step S15 or step S18, in step S19, the control computer 512 compares the layer pair number n with 60. If n is greater than or equal to 60 in step S19, then the resulting mirror is taken out and undergoes a film thickness inspection. If n is less than 60 in step S19, then in step S20, n is incremented, and the flow is returned to step S4 to repeat the process.

Through the above process, the first evaluation region 14 of a periodic multilayer film, the second evaluation region 15 of a molybdenum monolayer film, and the third evaluation region 16 of a silicon monolayer film are formed outside the effective region 13.

The deposition is performed through the above process. Actually, depositing as designed is difficult, and the film thickness in the mirror surface differs from the designed value. Therefore, an inspection of a multilayer film mirror is performed using an AFM (atomic force microscope), an EUV reflectometer, and X-ray diffraction. The AFM directly measures the effective region 13 to check the surface roughness. The EUV reflectometer and X-ray diffraction measure the reflectance at a plurality of places in the radial direction in each of the first evaluation region 14, the second evaluation region 15, and the third evaluation region 16. From the results, the film thickness distribution in the radial direction is derived using the above Bragg equation. By using the EUV reflectometer, the first evaluation region 14 can be measured with a measurement accuracy of 0.015% or more, which is higher than the measurement accuracy of about $\pm 0.15\%$ when ellipsometry is used.

Since deposition is performed while the substrate 11 is rotated, the unevenness of film thickness in the rotational direction is small. The film thickness distribution in the radial direction known by measuring the first evaluation region 14, the second evaluation region 15, and the third evaluation region 16 can be deemed to be equal to the film thickness distribution in the radial direction in the effective region 13. By adding the film thickness measurements of the first evaluation region 14, the second evaluation region 15, and the third evaluation region 16 together, the film thickness distribution of the effective region 13 can be estimated with a high degree of accuracy. The proportion of the second evaluation region 15 and the third evaluation region 16 to the whole film thickness is small. The film thickness distribution of the effective region 13 can be estimated by measuring only the first evaluation region 14. Therefore, depending on the required accuracy, the second evaluation region 15 and the third evaluation region 16 do not always have to be measured. When the film thickness distribution of the effective region 13 is estimated using only the first evaluation region 14, it is preferable to know the difference between the thickness of the multilayer film formed in the effective region 13 in the deposition process and the thickness of the multilayer film formed in the first evaluation region 14 in the deposition process.

After the thickness of the first evaluation region 14 is measured, the film thickness distribution of the effective region 13 can be estimated with a higher degree of accuracy based on the measured thickness of the first evaluation region 14 and the difference between the thickness of the multilayer film formed in the effective region 13 and the thickness of the multilayer film formed in the first evaluation region 14.

After the evaluation using the evaluation regions, mirrors that have a rough effective region 13, a low reflectance, non-uniform film period length, or a film period length different from the designed film period length are not mounted in an exposure apparatus.

Mirrors that do not comply with the specification in the inspection start from the polishing process again. If the surface roughness does not comply with a defined value, it can be attributed to mispolishing of the substrate or defects in the deposition process. Such a mirror does not pass the inspection. Mirrors that passed the inspection are mounted in an exposure apparatus.

After the re-polishing, the inspection is repeatedly performed by the same procedure. If the mirror complies with the specification or can be corrected, it is mounted in an exposure apparatus.

As described above, by forming the first evaluation region 14 composed of a periodic multilayer film in a region different from the effective region 13 on the substrate 11, a film thickness inspection can be performed with a high degree of accuracy. Mounting exposure mirrors that passed the inspection in an exposure apparatus makes it possible to transfer a finer pattern and manufacture highly integrated devices.

Two materials of a multilayer film are not limited to molybdenum and silicon. For example, it is known that a multilayer film formed of molybdenum and beryllium can be used for EUV light.

For the exposure mirror shown in the first embodiment, since the film thickness of each layer of the effective region is not limited, the design freedom is high. However, since each layer of the effective region is deposited at two times, the total number of steps of the deposition process is large.

For the exposure mirror of a second embodiment of the present invention, although the design freedom is lower, each layer of the effective region is deposited at one time, and therefore the total number of steps of the deposition process is smaller than that of the first embodiment.

The EUV exposure apparatus in which the exposure mirror of this embodiment is used, the sputtering deposition system with which the exposure mirror of this embodiment is made, and the method for evaluating the film thickness of the exposure mirror of this embodiment are the same as those in the first embodiment, so redundant description thereof will be omitted.

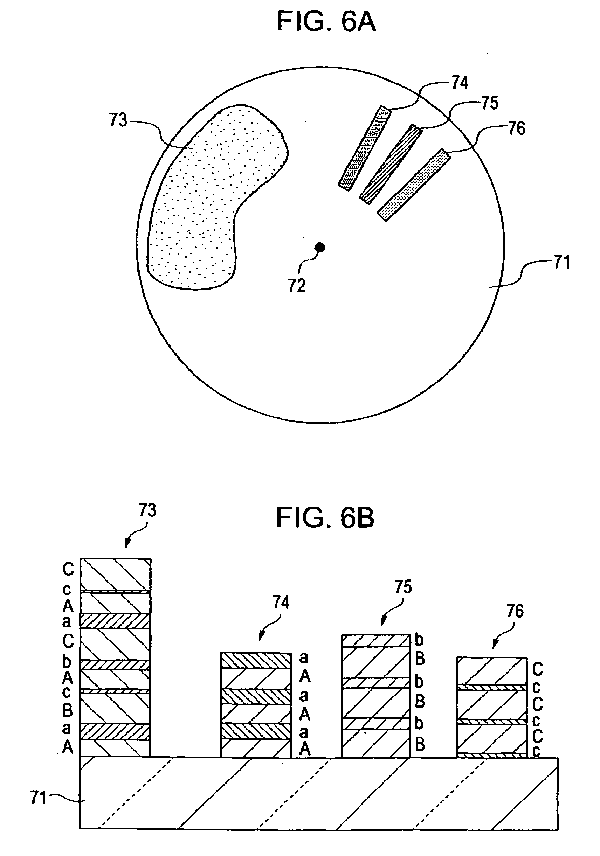

FIG. 6A is a front view of the exposure mirror of this embodiment, and FIG. 6B is a schematic sectional view thereof.

In FIGS. 6A and 6B, reference numeral 71 denotes a substrate, reference numeral 72 denotes the rotational center of the substrate, reference numeral 73 denotes an effective region, reference numeral 74 denotes a first evaluation region, reference numeral 75 denotes a second evaluation region, and reference numeral 76 denotes a third evaluation region.

The effective region 73 is composed of an aperiodic multilayer film. On top of the polished substrate 71, molybdenum (first material) layers and silicon (second material) layers are alternately deposited. The number of pairs of layers is 75. Three kinds of molybdenum layers A [nm], B [nm], and C [nm] in thickness, and three kinds of silicon layers a [nm], b [nm], and c [nm] in thickness constitute the effective region 73.

The first evaluation region 74, the second evaluation region 75, and the third evaluation region 76 are used for evaluation and inspection. Each of them is composed of a periodic multilayer film and deposited in a region different from the effective region 73 on the substrate 71.

The first evaluation region 74, the second evaluation region 75, and the third evaluation region 76 may each include at least five pairs of layers to augment measuring of the film thickness by measuring the reflectance. In this embodiment, the periodic multilayer film of the first evaluation region 74 is composed of 20 pairs of layers. Each molybdenum layer has a first film thickness (A [nm]), and each silicon layer has a second film thickness (a [nm]). The periodic multilayer film of the second evaluation region 75 is composed of 25 pairs of layers. Each molybdenum layer has a third film thickness (B [nm]) different from the first film thickness, and each silicon layer has a fourth film thickness (b [nm]) different from the second film thickness. The periodic multilayer film of the third evaluation region 76 is composed of 30 pairs of layers. Each molybdenum layer has a fifth film thickness (C [nm]) different from the first film thickness, and each silicon layer has a sixth film thickness (c [nm]) different from the second film thickness.

The first evaluation region 74, the second evaluation region 75, and the third evaluation region 76 each have a width that covers the effective region 73 in the radial direction from the rotational center 72 of the substrate toward the outer circumference. As in the first embodiment, in this embodiment each evaluation region may be divided in the radial direction.

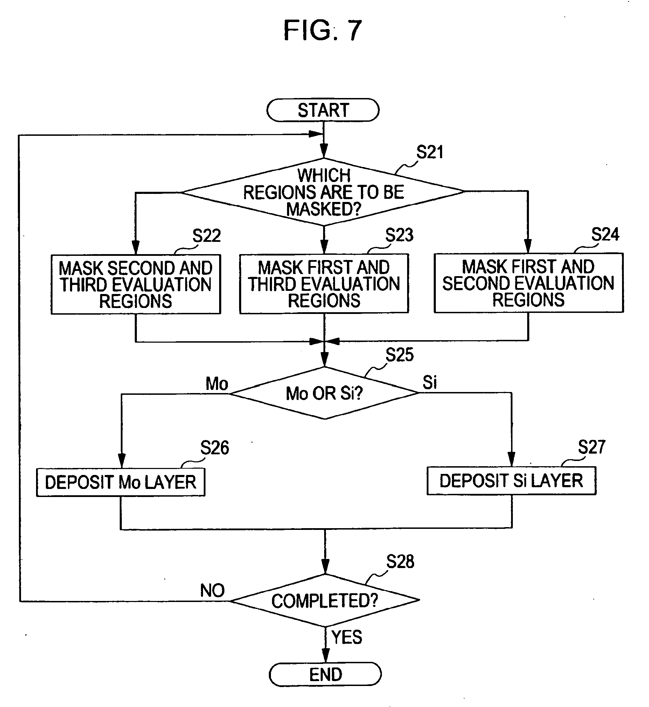

The multilayer film deposition process of the exposure mirror of this embodiment will be described with reference to the flowchart shown in FIG. 7.

A polished substrate 71 is placed in the sputtering deposition system 500 described with reference to FIG. 4 to start the deposition. In step S21, according to a deposition program, regions to be masked are selected. Since the first layer is a molybdenum layer A [nm] thick, the flow proceeds to step S22. In step S22, the second evaluation region 75 and the third evaluation region 76 are masked by a region selection mask 514. Next, in step S25, molybdenum is selected, and in step S26, a molybdenum layer is deposited. In step S28, it is determined whether the deposition is completed. If not, the flow returns to step S21. Since the second layer is a silicon layer a [nm] thick, a silicon layer is deposited through steps S22, S25, and S27.

Since the third layer is a molybdenum layer B [nm] thick, the flow proceeds to step S23. In step S23, the first evaluation region 74 and the third evaluation region 76 are masked by the region selection mask 514. Next, in step S25, molybdenum is selected, and in step S26, a molybdenum layer is deposited.

Since the fourth layer is a silicon layer c [nm] thick, the flow proceeds to step S24. In step S24, the first evaluation region 74 and the second evaluation region 75 are masked by the region selection mask 514. Next, in step S25, silicon is selected, and in step S27, a silicon layer is deposited. Such a flow is repeatedly performed until the deposition is completed.

As described above, by forming the first evaluation region 74, the second evaluation region 75, and the third evaluation region 76 each composed of a periodic multilayer film in regions different from the effective region 73 on the substrate 71, a film thickness inspection can be performed with a high degree of accuracy. Mounting exposure mirrors that passed the inspection in an exposure apparatus makes it possible to transfer a finer pattern and manufacture highly integrated devices.

A molybdenum-silicon multilayer film has a stress and therefore can affect the surface shape of the substrate. It is known to deposit a multilayer film layer (stress relaxation layer) for stress relaxation on top of a substrate and then deposit a multilayer film (reflective layer) for reflecting EUV light on top thereof in order to prevent deformation of the substrate. The reflective layer and the stress relaxation layer have stresses equal in size but opposite in direction, thereby preventing deformation of the substrate.

If the stress relaxation layer is not deposited with a desired degree of accuracy, the stress of the reflective layer cannot be cancelled and the substrate deforms. If the shape of the substrate is maintained as designed but the film period of the stress relaxation layer is non-uniform in the surface, the reflected wavefront is disturbed. To obtain high imaging performance, it is important to deposit the stress relaxation layer with a high degree of accuracy.

Based on these considerations, a third embodiment of the present invention relates to an exposure mirror including a stress relaxation layer in the effective region. Evaluation regions for evaluating the stress relaxation layer are provided in regions different from the effective region on the substrate.

The EUV exposure apparatus in which the exposure mirror of this embodiment is used, the sputtering deposition system with which the exposure mirror of this embodiment is made, and the method for evaluating the film thickness of the exposure mirror of this embodiment are the same as those in the first embodiment, so redundant description thereof will be omitted.

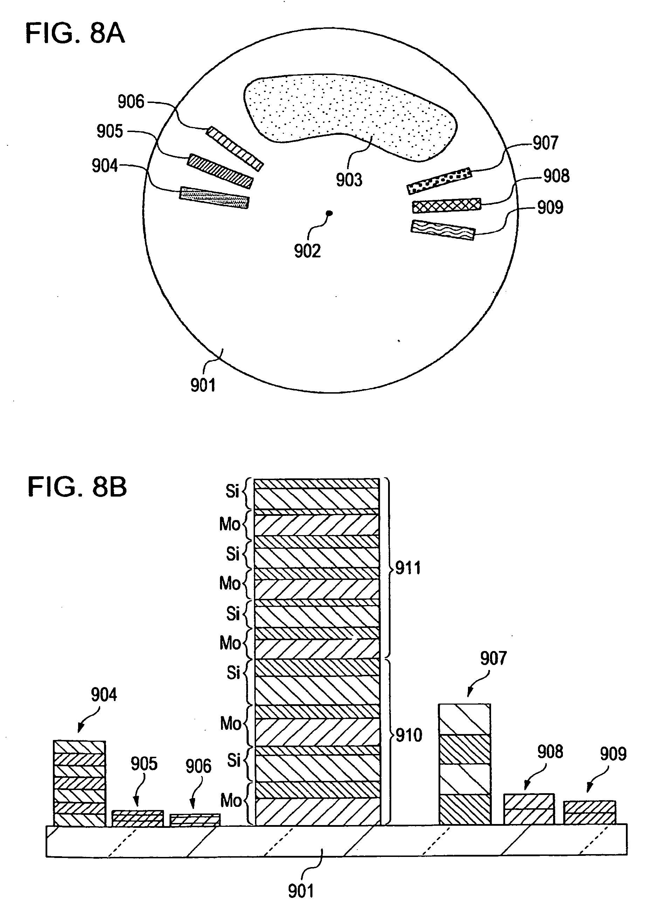

FIG. 8A is a front view of the exposure mirror of the third embodiment, and FIG. 8B is a schematic sectional view thereof.

In FIGS. 8A and 8B, reference numeral 901 denotes a substrate, reference numeral 902 denotes the rotational center of the substrate, reference numeral 903 denotes an effective region, reference numeral 904 denotes a first evaluation region, reference numeral 905 denotes a second evaluation region, reference numeral 906 denotes a third evaluation region, reference numeral 907 denotes a fourth evaluation region, reference numeral 908 denotes a fifth evaluation region, and reference numeral 909 denotes a sixth evaluation region. In FIG. 8B, reference numeral 910 denotes a stress relaxation layer composed of a periodic multilayer film, and reference numeral 911 denotes a reflective layer composed of an aperiodic multilayer film. The effective region 903 is composed of the stress relaxation layer 910 and the reflective layer 911.

The first evaluation region (first region) 904, the second evaluation region (second region) 905, and the third evaluation region (third region) 906 are regions for evaluating the reflective layer 911. The fourth evaluation region (fourth region) 907, the fifth evaluation region (fifth region) 908, and the sixth evaluation region (sixth region) 909 are regions for evaluating the stress relaxation layer 910.

The stress relaxation layer 910 is deposited after the polishing of the substrate 901. Although the material of the stress relaxation layer 910 is not limited, the stress relaxation layer 910 preferably is formed of the same material as the reflecting layer 911 from the viewpoint of simplification of the deposition system. When the reflective layer 911 has a compression stress, the stress relaxation layer 910 is given a back stress thereof, that is, a tensile stress. The stress of a molybdenum-silicon multilayer film differs depending on the thickness. Therefore, by appropriately setting the film period and the number of films, a molybdenum-silicon multilayer film can be used as a reflective layer, or a stress relaxation layer that cancels the stress of the reflective layer.

Since the stress relaxation layer 910 is a periodic multilayer film, when the film period of the stress relaxation layer 910 is an appropriate value to measure the film thickness by measuring the reflectance, the same film structure as the stress relaxation layer 910 can be formed in the fourth evaluation region 907. In this case, the fifth evaluation region 908 and the sixth evaluation region 909 shown in FIG. 8B are made redundant. When the film period of the stress relaxation layer 910 is not an appropriate value to measure the film thickness, the film thickness of the fourth evaluation region 907 is set to a value suitable for measurement and the fifth evaluation region 908 and the sixth evaluation region 909 are formed through the same deposition process as that shown in the first embodiment.

For the reflective layer 911 deposited on top of the stress relaxation layer 910 and the regions for evaluating the reflective layer 911, that is, the first evaluation region 904, the second evaluation region 905, and the third evaluation region 906, the film structures and the deposition process of the first embodiment or the second embodiment are used.

The evaluation method using the stress relaxation layer evaluation regions is the same as that using the reflective layer evaluation regions.

As described above, by forming not only the regions for evaluating the reflective layer 911 but also the regions for evaluating the stress relaxation layer 910 in regions different from the effective region 903 on the substrate 901, not only the film thickness inspection of the reflective layer 911 but also the inspection of the stress relaxation layer 910 can be performed with a high degree of accuracy. Mounting exposure mirrors that passed the inspection in an exposure apparatus makes it possible to transfer a finer pattern and manufacture highly integrated devices.

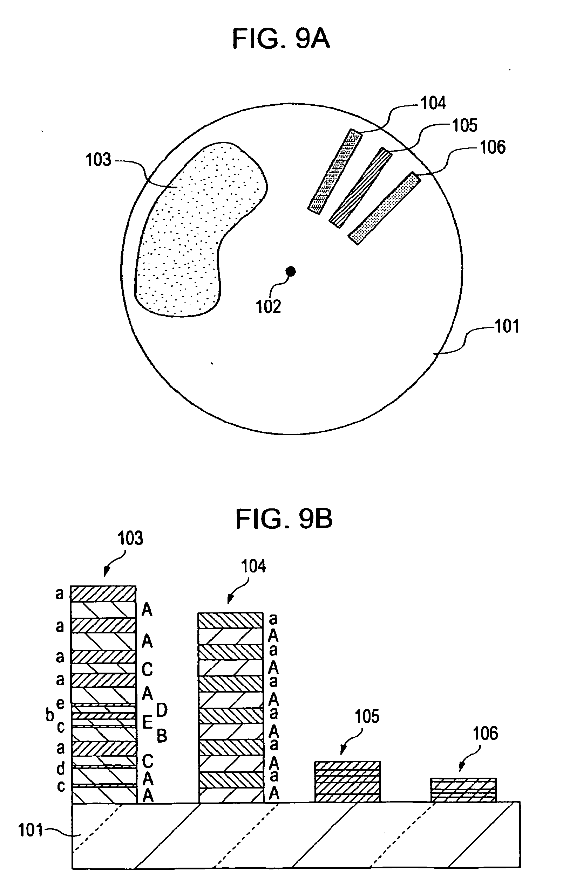

FIG. 9A is a front view of an exposure mirror of a fourth embodiment of the present invention, and FIG. 9B is a schematic sectional view thereof.

In FIGS. 9A and 9B, reference numeral 101 denotes a substrate, reference numeral 102 denotes the rotational center of the substrate, reference numeral 103 denotes an effective region, reference numeral 104 denotes a first evaluation region, reference numeral 105 denotes a second evaluation region, and reference numeral 106 denotes a third evaluation region.

The EUV exposure apparatus in which the exposure mirror of this embodiment is used, the sputtering deposition system with which the exposure mirror of this embodiment is made, and the method for evaluating the film thickness of the exposure mirror of this embodiment are the same as those in the first embodiment, so redundant description thereof will be omitted.

The effective region 103 is composed of an aperiodic multilayer film. On top of the polished substrate 101, molybdenum (first material) layers and silicon (second material) layers are alternately deposited. The number of pairs of layers is 60.

Six kinds of molybdenum layers A [nm], B [nm], C [nm], D [nm], E [nm], and F [nm] in thickness, and five kinds of silicon layers a [nm], b [nm], c [nm], d [nm], and e [nm] in thickness constitute the effective region 103.

The first evaluation region 104, the second evaluation region 105, and the third evaluation region 106 are used for evaluation and inspection. Each of them is composed of a periodic multilayer film and deposited in a region different from the effective region 103 on the substrate 101.

The periodic multilayer film of the first evaluation region 104 is composed of molybdenum layers A [nm] thick and silicon layers a [nm] thick. The first evaluation region 104 is deposited through the same deposition process as that of the second embodiment. The first evaluation region 104 is appropriately masked so that molybdenum layers A [nm] thick and silicon layers a [nm] thick are alternately deposited. For example, when molybdenum layers A [nm] thick are consecutively deposited, the first evaluation region 104 is masked until a silicon layer a [nm] thick is deposited, to prevent molybdenum layers A [nm] thick from being consecutively deposited in the first evaluation region 104.

In this embodiment, the first evaluation region 104 is beneficially composed of at least five pairs of layers to augment measuring of the film thickness by measuring the reflectance, although fewer than five pairs of layers may alternatively be used.

The second evaluation region 105 is composed of molybdenum layers having film thicknesses other than that of the molybdenum layers deposited in the first evaluation region 104, that is, B [nm], C [nm], D [nm], E [nm], and F [nm]. The third evaluation region 106 is composed of silicon layers having film thicknesses other than that of the silicon layers deposited in the first evaluation region 104, that is, b [nm], c [nm], d [nm], and e [nm].

The first evaluation region 104, the second evaluation region 105, and the third evaluation region 106 each have a width that covers the effective region 103 in the radial direction from the rotational center 102 of the substrate toward the outer circumference. As in the first embodiment, in this embodiment each evaluation region may be divided in the radial direction.

The evaluation regions other than the first evaluation region 104 can be deposited through the same deposition process as that of the second embodiment, so redundant description thereof will be omitted.

If the first evaluation region 104 is designed so as to be composed of five or more pairs of layers, since each layer of the effective region 103 is deposited at one time as in the second embodiment, the total number of steps of the deposition process can be reduced. The other advantages are the same as those of the exposure mirrors of the first and second embodiments.

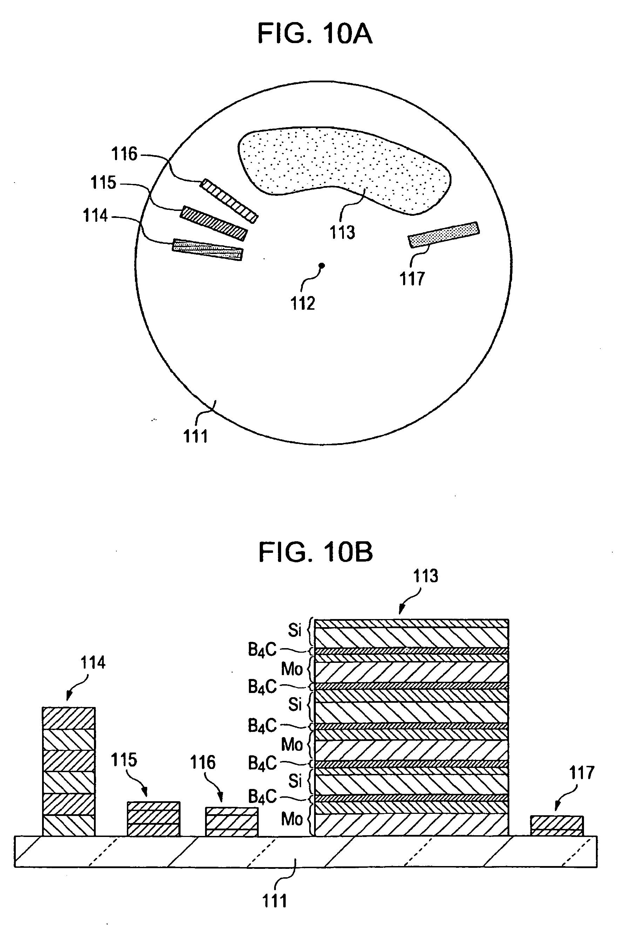

FIG. 10A is a front view of an exposure mirror of a fifth embodiment of the present invention, and FIG. 10B is a schematic sectional view thereof.

The EUV exposure apparatus in which the exposure mirror of this embodiment is used, the sputtering deposition system with which the exposure mirror of this embodiment is made, and the method for evaluating the film thickness of the exposure mirror of this embodiment are the same as those in the first embodiment, so redundant description thereof will be omitted.

In FIGS. 10A and 10B, reference numeral 111 denotes a substrate, reference numeral 112 denotes the rotational center of the substrate, reference numeral 113 denotes an effective region, reference numeral 114 denotes a first evaluation region, reference numeral 115 denotes a second evaluation region, reference numeral 116 denotes a third evaluation region, and reference numeral 117 denotes a fourth evaluation region.

The exposure mirror of this embodiment is based on the structure shown in the first to fourth embodiments but differs in that boron carbide (third material) is deposited between molybdenum (first material) and silicon (second material) to form third material layers serving as anti-diffusion layers. The fourth evaluation region (fourth region) 117, which is a boron carbide single layer, is provided in a region different from the effective region 113 on the substrate 111.

Each evaluation region has a width that covers the effective region 113 in the radial direction from the rotational center 112 of the substrate toward the outer circumference. As in the first embodiment, in this embodiment each evaluation region may be divided in the radial direction.

The film thickness of a multilayer film including anti-diffusion layers such as the effective region 113 in this embodiment can also be estimated with a high degree of accuracy by measuring the film thickness of the fourth evaluation region 117 using the film thickness measuring method shown in the first embodiment and evaluating the measurement together with the measurements of the other evaluation regions. The proportion of the fourth evaluation region 117 to the whole film thickness is small. If the fourth evaluation region 117 is omitted, the effect on the estimation of the film thickness distribution of the effective region 113 is small.

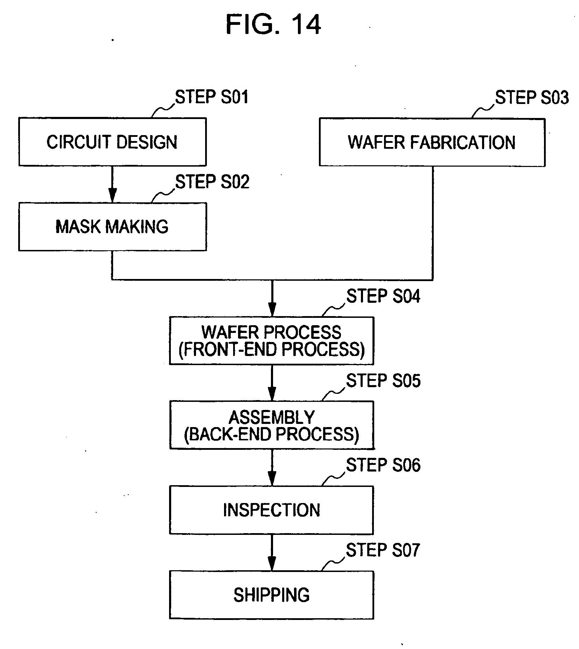

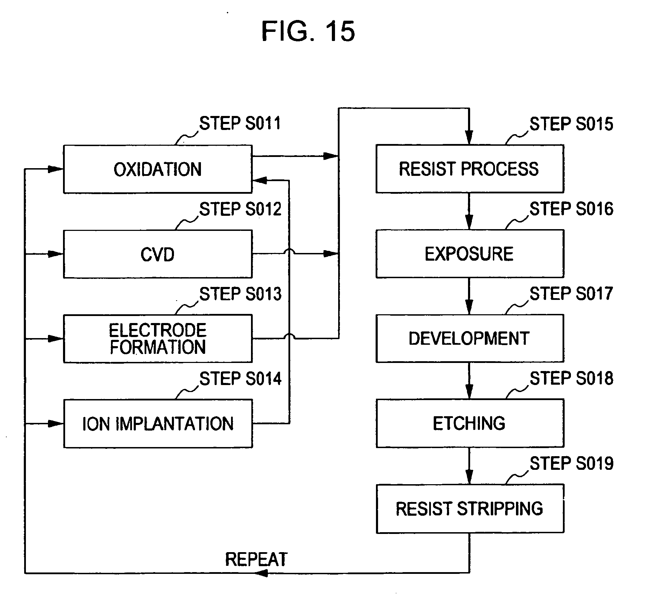

Next, with reference to FIGS. 14 and 15, a sixth embodiment is described of a device manufacturing method using an exposure apparatus equipped with exposure mirrors of the present invention.

FIG. 14 is a flowchart for illustrating the manufacture of devices (for example, semiconductor chips such as ICs and LSIs, LCDs, and CCDs). A method for manufacturing semiconductor chips will next be described.

First, in step S01 (circuit design), a semiconductor device circuit is designed. In step S02 (mask making), masks are made based on the designed circuit pattern. In step S03 (wafer fabrication), a wafer is fabricated from a material such as silicon. In step S04 (wafer process), which is called a front-end process, an actual circuit is formed on the wafer by lithography using the masks and the above-described exposure apparatus. In step S05 (assembly), which is called a back-end process, semiconductor chips are made from the wafer processed in step S04. Step S05 includes an assembly process (dicing and bonding) and a packaging process (chip encapsulation). In step S06 (inspection), inspections such as an operation confirmation test and a durability test of the semiconductor devices made in step S05 are conducted. Through these processes, semiconductor devices are completed, and shipped in step S07.

FIG. 15 is a detailed flowchart of the wafer process of step S04.

In step S011 (oxidation), the surface of the wafer is oxidized. In step S012 (CVD), an insulating film is formed on the surface of the wafer. In step S013 (electrode formation), electrodes are formed on the wafer. In step S014 (ion implantation), ions are implanted in the wafer. In step S015 (resist process), the wafer is coated with photoresist. In step S016 (exposure), the circuit pattern of the reticle is projected onto the wafer with the exposure apparatus. In step S017 (development), the exposed wafer is developed. In step S018 (etching), portions of the wafer not covered by the developed resist image are scraped off. In step S019 (resist stripping), the resist, which is no longer necessary after the etching, is removed.

By repeatedly performing these steps, a multilayer circuit pattern is formed on the wafer. The device manufacturing method of this embodiment makes it possible to manufacture more reliable devices using the high-accuracy exposure performance based on the application of exposure mirrors of the present invention.

While the present invention has been described with reference to exemplary embodiments, it is to be understood that the invention is not limited to the disclosed exemplary embodiments. The scope of the following claims is to be accorded the broadest interpretation.

**Claims**

1. An exposure mirror comprising:

   a substrate (11);
   an effective region (13) formed on the substrate (11) and including a multilayer film in which layers of a first material and layers of a second material having a refractive index different from that of the first material are alternately deposited; and
   a first region (14) composed of a multilayer film in which layers of the first material and layers of the second material are alternately deposited,
   wherein thickness of the layers of the first material and thickness of the layers of the second material in the effective region (13) are aperiodic, and
   thickness of the layers of the first material and thickness of the layers of the second material in the first region (14) are periodic, **characterized in that** said first region is formed in a region different from the effective region (13) on the substrate (11).

2. The exposure mirror according to Claim 1, wherein the number of the layers of the first material in the effective region (13) is equal to the number of the layers of the first material in the first region (14), and the number of the layers of the second material in the effective region (13) is equal to the number of the layers of the second material in the first region (14).

3. The exposure mirror according to Claim 1, wherein the layers of the first material and the layers of the second material in the first region (14) each have uniform thickness.

4. The exposure mirror according to Claim 1, further comprising a second region (15) formed in a region different from the effective region (13) and the first region (14) on the substrate (11) and composed of a multilayer film in which layers of the first material are deposited, wherein total thickness of the layers of the first material in the second region (15) is equal to the difference between total thickness of the layers of the first material deposited in the effective region (13) and total thickness of the layers of the first material deposited in the first region (14).

5. The exposure mirror according to Claim 4, further comprising a third region (16) formed in a region different from the effective region (13), the first region (14), and the second region (15) on the substrate (11) and composed of a multilayer film in which layers of the second material are deposited, wherein total thickness of the layers of the second material in the third region (16) is equal to the difference between total thickness of the layers of the second material deposited in the effective region (13) and total thickness of the layers of the second material deposited in the first region (14).

6. The exposure mirror according to Claim 1, wherein the layers of the first material in the effective region (13) include layers having a plurality of kinds of thicknesses including a first thickness, the layers of the second material in the effective region (13) include layers having a plurality of kinds of thicknesses including a second thickness, and in the multilayer film of the first region (14), the layers of the first material having the first thickness and the layers of the second material having the second thickness are alternately deposited.

7. The exposure mirror according to Claim 6, wherein the layers of the first material in the effective region (13) include layers having a plurality of kinds of thicknesses including a third thickness different from the first thickness, the layers of the second material in the effective region (13) include layers having a plurality of kinds of thicknesses including a fourth thickness different from the second thickness, and further comprising a second region (15) composed of a periodic multilayer film in which layers of the first material having the third thickness and layers of the second material having the fourth thickness are alternately deposited.

8. The exposure mirror according to Claim 6, further comprising a second region (15) composed only of a layer of the first material having the same thickness as total thickness of the layers of the first material that constitute the aperiodic multilayer film included in the effective region (13) and that have thicknesses other than the first thickness, and a third region (16) composed only of a layer of the second material having the same thickness as total thickness of the layers of the second material that constitute the aperiodic multilayer film included in the effective region (13) and that have thicknesses other than the second thickness.

9. The exposure mirror according to Claim 1, wherein the first material is molybdenum, and the second material is silicon.

10. The exposure mirror according to Claim 1, wherein the surface of the substrate (11) where the effective region (13) and the first region (14) are formed is rotationally symmetric, and the first region (14) is formed in such a shape that the film thickness distribution in the radial direction of the effective region (13) can be evaluated.

11. The exposure mirror according to Claim 1, wherein the multilayer film of the effective region (13) includes layers of a third material serving as anti-diffusion layers between the layers of the first material and the layers of the second material deposited alternately.

12. The exposure mirror according to Claim 1, wherein the effective region (13) includes a reflective layer (911) composed of an aperiodic multilayer film and a stress relaxation layer (910), and the first region (14) is a region for evaluating the reflective layer.

13. The exposure mirror according to Claim 12, wherein the stress relaxation layer is composed of a periodic multilayer film, and further comprising a region (907) that is located in a region different from the effective region (13) and the first region (14) on the substrate (11), that is composed of a multilayer film having the same structure as the stress relaxation layer, and that is used for evaluating the stress relaxation layer.

14. An exposure apparatus comprising:

an illumination optical system that illuminates a reticle (414); and
a projection optical system that projects a pattern formed on the reticle (414) onto a wafer (417),
wherein at least one of the illumination optical system and the projection optical system has the exposure mirror according to Claim 1.

15. A method for manufacturing an exposure mirror, comprising:

forming, on a substrate (11), an effective region (13) including a multilayer film in which layers of a first material and layers of a second material having a refractive index different from that of the first material are alternately deposited;
forming a first region (14) composed of a multilayer film in which layers of the first material and layers of the second material are alternately deposited,
wherein thickness of the layers of the first material and thickness of the layers of the second material in the effective region (13) are aperiodic, and
thickness of the layers of the first material and thickness of the layers of the second material in the first region (14) are periodic; **characterized in that** said first region is formed in a region different from the effective region (13) on the substrate, and **in that** said method further comprises
measuring thickness of the multilayer film formed in the first region (14); and
estimating and evaluating the thickness of the multilayer film formed in the effective region (13) based on the thickness of the multilayer film formed in the first region (14) measured in the measuring step.

16. The method according to Claim 15, wherein each layer of the first material in the effective region (13) and each layer of the first material in the first region (14) are formed at the same time, and each layer of the second material in the effective region (13) and each layer of the second material in the first region (14) are formed at the same time.

**Patentansprüche**

1. Belichtungsspiegel, umfassend:

ein Substrat (11);

eine auf dem Substrat (11) ausgebildete wirksame Zone (13), beinhaltend einen Multischicht-Film, bei welchem Schichten eines ersten Materials und Schichten eines zweiten Materials, deren Brechungsindex verschieden ist, alternierend niedergeschlagen sind; und

eine erste Zone (14), die sich zusammensetzt aus einem Multischicht-Film, bei dem Schichten des ersten Materials und Schichten des zweiten Materials alternierend niedergeschlagen sind,

wobei die Dicke der Schichten des ersten Materials und die des zweiten Materials in der wirksamen Zone (13) aperiodisch sind, und

die Dicke der Schichten des ersten Materials und die des zweiten Materials in der ersten Zone (14) periodisch sind,

**dadurch gekennzeichnet, dass**

die erste Zone ausgebildet ist auf dem Substrat (11) in einer Zone, die verschieden ist von der wirksamen Zone (1 3).

**2.** Belichtungsspiegel nach Anspruch 1, wobei
die Anzahl der Schichten des ersten Materials in der wirksamen Zone (13) gleich der Anzahl der Schichten des ersten Materials in der ersten Zone (14) ist, und die Anzahl der Schichten des zweiten Materials in der wirksamen Zone (13) gleich der Anzahl der Schichten des zweiten Materials in der ersten Zone (14) ist.

**3.** Belichtungsspiegel nach Anspruch 1, wobei
die Schichten des ersten Materials und die des zweiten Materials in der ersten Zone (14) je gleichförmige Dicke haben.

**4.** Belichtungsspiegel nach Anspruch 1, ferner umfassend:

eine zweite Zone (15), die ausgebildet ist auf dem Substrat (11) in einer Zone, die verschieden ist von der wirksamen Zone (13) und der ersten Zone (14) und zusammengesetzt ist aus einem Multischicht-Film, bei welchem Schichten des ersten Materials niedergeschlagen sind, wobei die Gesamtdicke der Schichten des ersten Materials in der zweiten Zone (15) gleich der Differenz ist zwischen der Gesamtdicke der Schichten des in der wirksamen Zone (13) niedergeschlagenen ersten Materials und der Gesamtdicke der Schichten des in der ersten Zone (14) niedergeschlagenen ersten Materials.

**5.** Belichtungsspiegel nach Anspruch 4, ferner umfassend:

eine dritte Zone (16), die ausgebildet ist auf dem Substrat (11) in einer Zone, die verschieden ist von der wirksamen Zone (13), der ersten Zone (14) sowie der zweiten Zone (15) und zusammengesetzt ist aus einem Multischicht-Film, bei welchem Schichten des zweiten Materials niedergeschlagen sind; wobei die Gesamtdicke der Schichten des zweiten Materials in der dritten Zone (16) gleich der Differenz ist zwischen der Gesamtdicke der Schichten des in der wirksamen Zone (13) niedergeschlagenen zweiten Materials und der Gesamtdicke der Schichten des in der ersten Zone (14) niedergeschlagenen zweiten Materials.

**6.** Belichtungsspiegel nach Anspruch 1, wobei
die Schichten des ersten Materials in der wirksamen Zone (13) Schichten beinhalten, welche mehrere Dicken-Arten haben, und zwar beinhaltend eine erste Dicke, wobei die Schichten des zweiten Materials in der wirksamen Zone (13) Schichten beinhalten, welche mehrere Dicken-Arten einschließlich einer zweiten Dicke haben und bei dem Multischicht-Film der ersten Zone (14) die Schichten des ersten Materials, die die erste Dicke haben, und die Schichten des zweiten Materials, die die zweite Dicke haben, alternierend niedergeschlagen sind.

**7.** Belichtungsspiegel nach Anspruch 6, wobei
die Schichten des ersten Materials in der wirksamen Zone (13) Schichten beinhalten, welche mehrere Dicken-Arten einschließlich einer dritten Dicke, die von der ersten Dicke verschieden ist, haben, wobei die Schichten des zweiten Materials in der wirksamen Zone (13) Schichten beinhalten mit mehreren Dicken-Arten einschließlich einer vierten Dicke, die verschieden ist von der zweiten Dicke, und ferner umfassend eine zweite Zone (15), die zusammengesetzt ist aus einem periodischen Multischicht-Film, in welchem Schichten des ersten Materials, die die dritte Dicke haben, und Schichten des zweiten Materials, die die vierte Dicke haben, alternierend niedergeschlagen sind.

**8.** Belichtungsspiegel nach Anspruch 6, ferner umfassend:

eine zweite Zone (15), die zusammengesetzt ist nur aus einer Schicht des ersten Materials, welche die gleiche Dicke als Gesamtdicke der Schichten des ersten Materials haben, welche in der wirksamen Zone (13), den in dieser inkludierten aperiodischen Multischicht-Film bilden und welche andere Dicken als die erste Dicke haben, sowie eine dritte Zone (16), die zusammengesetzt ist nur aus einer Schicht des zweiten Materials, welche die gleiche Dicke als Gesamtdicke der Schichten des zweiten Materials haben, welche in der wirksamen Zone (13), den in dieser inkludierten aperiodischen Multischicht-Film bilden und welche andere Dicken als die zweite Dicke haben.

9. Belichtungsspiegel nach Anspruch 1, wobei
das erste Material Molybdän ist und das zweite Material Silicium ist.

10. Belichtungsspiegel nach Anspruch 1, wobei
die Fläche des Substrates (11), auf welcher die wirksame Zone (13) und die erste Zone (14) ausgebildet sind, rotationssymmetrisch ist, und die erste Zone (14) in einer solchen Gestalt ausgebildet ist, dass die Schichtdickenverteilung in radialer Richtung der wirksamen Zone (13) ermittelt werden kann.

11. Belichtungsspiegel nach Anspruch 1, wobei
der Multischicht-Film der wirksamen Zone (13) Schichten eines dritten Materials beinhaltet, welche als Antidiffusionsschichten zwischen den Schichten des ersten Materials und den alternierend niedergeschlagenen Schichten des zweiten Materials dienen.

12. Belichtungsspiegel nach Anspruch 1, wobei
die wirksame Zone (13) eine reflektierende Schicht (911) beinhaltet, welche zusammengesetzt ist aus einem aperiodischen Multischicht-Film und einer Spannungsabbauschicht (910) und die erste Zone (14) eine Zone zum Ermitteln der reflektierenden Schicht ist.

13. Belichtungsspiegel nach Anspruch 12, wobei
die Spannungsabbauschicht zusammengesetzt ist aus einem periodischen Multischicht-Film und ferner eine Zone (907) umfasst, welche auf dem Substrat (11) in einer von der wirksamen Zone (13) und der ersten Zone (14) verschiedenen Zone angeordnet ist, welche zusammengesetzt ist aus einem Multischicht-Film, der die gleiche Struktur besitzt wie die Spannungsabbauschicht, und welche zum Ermitteln der Spannungsabbauschicht verwendet wird.

14. Belichtungsvorrichtung, umfassend:

ein optisches Beleuchtungssystem, das eine Netzstruktur (414) (reticle) beleuchtet; und
ein optisches Projektionssystem, das ein auf der Netzstruktur (414) erzeugtes Muster auf einen Wafer (417) projiziert,
wobei wenigstens ein System von dem optischen Beleuchtungssystem und dem optischen Projektionssystem den Belichtungsspiegel nach Anspruch 1 hat.

15. Verfahren zum Herstellen eines Belichtungsspiegels, umfassend:

auf einem Substrat (11) erfolgendes Ausbilden einer wirksamen Zone (13), die einen Multischicht-Film beinhaltet, bei welchem Schichten eines ersten Materials und Schichten eines zweiten Materials mit einem Brechungsindex, der verschieden ist von dem des ersten Materials, alternierend niedergeschlagen werden;
Ausbilden einer ersten Zone (14), die zusammengesetzt ist aus einem Multischicht-Film, in welchem Schichten des ersten Materials und Schichten des zweiten Materials alternierend niedergeschlagen werden;
wobei die Dicke der Schichten des ersten Materials und die Dicke der Schichten des zweiten Materials in der wirksamen Zone (13) aperiodisch sind, und
die Dicke der Schichten des ersten Materials und die Dicke der Schichten des zweiten Materials in der ersten Zone (14) periodisch sind;
**dadurch gekennzeichnet, dass** die erste Zone auf dem Substrat ausgebildet wird in einer Zone, die verschieden ist von der wirksamen Zone (13), und dass das Verfahren ferner umfasst
Messen der Dicke des in der ersten Zone (14) erzeugten Multischicht-Films; und
Nachweisen und Ermitteln der Dicke des in der wirksamen Zone (13) erzeugten Multischicht-Films, basierend auf der Dicke des in der ersten Zone (14) ausgebildeten Multischicht-Films wie diese gemessen wird in dem Messschritt.

**16.** Verfahren nach Anspruch 15, wobei jede Schicht des ersten Materials in der wirksamen Zone (13) und jede Schicht des ersten Materials in der ersten Zone (14) zur gleichen Zeit ausgebildet werden, und jede Schicht des zweiten Materials in der wirksamen Zone (13) und jede Schicht des zweiten Materials in der ersten Zone (14) gleichzeitig ausgebildet werden.

**Revendications**

**1.** Miroir d'exposition comprenant :

un substrat (11) ;
une région effective (13) formée sur le substrat (11) et comportant un film multicouche dans lequel des couches d'un premier matériau et des couches d'un deuxième matériau ayant un indice de réfraction différent de celui du premier matériau sont déposées en alternance ; et
une première région (14) composée d'un film multicouche dans lequel des couches du premier matériau et des couches du deuxième matériau sont déposées en alternance,
dans lequel l'épaisseur des couches du premier matériau et l'épaisseur des couches du deuxième matériau, dans la région effective (13), sont apériodiques, et
l'épaisseur des couches du premier matériau et l'épaisseur des couches du deuxième matériau, dans la première région (14), sont périodiques, **caractérisé en ce que** ladite première région est formée dans une région différente de la région effective (13) sur le substrat (11).

**2.** Miroir d'exposition selon la revendication 1, dans lequel le nombre des couches du premier matériau, dans la région effective (13), est égal au nombre des couches du premier matériau, dans la première région (14), et dans lequel le nombre des couches du deuxième matériau, dans la région effective (13), est égal au nombre des couches du deuxième matériau, dans la première région (14).

**3.** Miroir d'exposition selon la revendication 1, dans lequel les couches du premier matériau et les couches du deuxième matériau, dans la première région (14), ont chacune une épaisseur uniforme.

**4.** Miroir d'exposition selon la revendication 1, comprenant en outre une deuxième région (15) formée dans une région différente de la région effective (13) et de la première région (14), sur le substrat (11), et composée d'un film multicouche dans lequel sont déposées des couches du premier matériau, dans lequel l'épaisseur totale des couches du premier matériau, dans la deuxième région (15), est égale à la différence entre l'épaisseur totale des couches du premier matériau déposé dans la région effective (13) et l'épaisseur totale des couches du premier matériau déposé dans la première région (14).

**5.** Miroir d'exposition selon la revendication 4, comprenant en outre une troisième région (16) formée dans une région différente de la région effective (13), de la première région (14), et de la deuxième région (15) sur le substrat (11), et composée d'un film multicouche dans lequel sont déposées des couches du deuxième matériau, dans lequel l'épaisseur totale des couches du deuxième matériau, dans la troisième région (16), est égale à la différence entre l'épaisseur totale des couches du deuxième matériau déposé dans la région effective (13), et l'épaisseur totale des couches du deuxième matériau déposé dans la première région (14).

**6.** Miroir d'exposition selon la revendication 1, dans lequel les couches du premier matériau, dans la région effective (13), comprennent des couches ayant une pluralité de types d'épaisseurs comprenant une première épaisseur, les couches du deuxième matériau, dans la région effective (13), comprennent des couches ayant une pluralité de types d'épaisseurs comprenant une deuxième épaisseur et, dans le film multicouche de la première région (14), les couches du premier matériau ayant la première épaisseur et les couches du deuxième matériau ayant la deuxième épaisseur sont déposées en alternance.

**7.** Miroir d'exposition selon la revendication 6, dans lequel les couches du premier matériau, dans la région effective (13), comprennent des couches ayant une pluralité de types d'épaisseurs comprenant une troisième épaisseur différente de la première épaisseur, les couches du deuxième matériau, dans la région effective (13), comprennent des couches ayant une pluralité de types d'épaisseurs comprenant une quatrième épaisseur différente de la deuxième épaisseur, et comprenant en outre une deuxième région (15) composée d'un film multicouche périodique dans lequel des couches du premier matériau ayant la troisième épaisseur et des couches du deuxième matériau ayant la quatrième épaisseur sont déposées en alternance.

8. Miroir d'exposition selon la revendication 6, comprenant en outre une deuxième région (15) uniquement composée d'une couche du premier matériau ayant la même épaisseur que l'épaisseur totale des couches du premier matériau qui constituent le film multicouche apériodique compris dans la région effective (13), et qui ont des épaisseurs autres que la première épaisseur, et une troisième région (16) uniquement composée d'une couche du deuxième matériau ayant la même épaisseur que l'épaisseur totale des couches du deuxième matériau qui constituent le film multicouche apériodique compris dans la région effective (13) et qui ont des épaisseurs autres que la deuxième épaisseur.

9. Miroir d'exposition selon la revendication 1, dans lequel le premier matériau est le molybdène et le deuxième matériau est le silicium.

10. Miroir d'exposition selon la revendication 1, dans lequel la surface du substrat (11) où sont formées la région effective (13) et la première région (14) est symétrique de rotation, et dans lequel la première région (14) est formée de façon à avoir une forme telle que la répartition d'épaisseur du film dans la direction radiale de la région effective (13) peut être évaluée.

11. Miroir d'exposition selon la revendication 1, dans lequel le film multicouche de la région effective (13) comprend des couches d'un troisième matériau jouant le rôle de couches anti-diffusion entre les couches du premier matériau et les couches du deuxième matériau déposées en alternance.

12. Miroir d'exposition selon la revendication 1, dans lequel la région effective (13) comprend une couche réfléchissante (911) composée d'un film multicouche apériodique et d'une couche de relaxation de la contrainte (910), et la première région (14) est une région destinée à évaluer la couche réfléchissante.

13. Miroir d'exposition selon la revendication 12, dans lequel la couche de relaxation de la contrainte est composée d'un film multicouche périodique, et comprenant en outre une région (907) qui est située dans une région différente de la région effective (13) et de la première région (14) sur le substrat (11), qui est composée d'un film multicouche ayant la même structure que la couche de relaxation de la contrainte, et qui est utilisée pour évaluer la couche de relaxation de la contrainte.

14. Appareil d'exposition comprenant :

   un système optique d'éclairement qui éclaire un réticule (414) ; et
   un système optique de projection qui projette un motif formé sur le réticule (414) vers une plaquette (417) ;
   dans lequel au moins l'un du système optique d'éclairement du système optique de projection comporte un miroir d'exposition selon la revendication 1.

15. Procédé de fabrication d'un miroir d'exposition, consistant à :

   former, sur un substrat (11), une région effective (13) comprenant un film multicouche dans lequel des couches d'un premier matériau et des couches d'un deuxième matériau ayant un indice de réfraction différent de celui du premier matériau sont déposées en alternance ;
   former une première région (14) composée d'un film multicouche dans lequel des couches du premier matériau et des couches du deuxième matériau sont déposées en alternance,
   dans lequel l'épaisseur des couches du premier matériau et l'épaisseur des couches du deuxième matériau, dans la région effective (13), sont apériodiques, et
   l'épaisseur des couches du premier matériau et l'épaisseur des couches du deuxième matériau, dans la première région (14), sont périodiques ;
   **caractérisé en ce que** ladite première région est formée dans une région différente de la région effective (13) sur le substrat, et **en ce que** ledit procédé consiste en outre à :

      mesurer l'épaisseur du film multicouche formé dans la première région (14) ; et
      estimer et évaluer l'épaisseur du film multicouche formé dans la région effective (13) sur la base de l'épaisseur du film multicouche formé dans la première région (14), mesurée lors de l'étape de mesure.

16. Procédé selon la revendication 15, dans lequel chaque couche du premier matériau, dans la région effective (13), et chaque couche du premier matériau, dans la première région (14), sont formées en même temps, et chaque couche du deuxième matériau, dans la région effective (13), et chaque couche du deuxième matériau, dans la première région (14), sont formées en même temps.

FIG. 1

# FIG. 2A

# FIG. 2B

# FIG. 3

# FIG. 4

# FIG. 5

SUBSTRATE POLISHING PROCESS

| | |
|---|---|
| PLACE SUBSTRATE IN DEPOSITION SYSTEM | S1 |

| | |
|---|---|
| n = 1 | S2 |

| | |
|---|---|
| MASK SECOND AND THIRD EVALUATION REGIONS | S3 |

S4 — Mn > 2 nm?

**YES** (left branch):

| | |
|---|---|
| DEPOSIT MOLYBDENUM LAYER 2 [nm] THICK | S5 |

| | |
|---|---|
| MASK FIRST AND THIRD EVALUATION REGIONS | S6 |

| | |
|---|---|
| DEPOSIT MOLYBDENUM LAYER Mn−2 [nm] THICK | S7 |

**NO** (right branch):

| | |
|---|---|
| DEPOSIT MOLYBDENUM LAYER Mn [nm] THICK | S8 |

| | |
|---|---|
| MASK EFFECTIVE REGION AND SECOND AND THIRD EVALUATION REGIONS | S9 |

| | |
|---|---|
| DEPOSIT MOLYBDENUM LAYER 2−Mn [nm] THICK | S10 |

| | |
|---|---|
| MASK SECOND AND THIRD EVALUATION REGIONS | S11 |

S12 — Sn > 5 nm?

**YES** (left branch):

| | |
|---|---|
| DEPOSIT SILICON LAYER 5 [nm] THICK | S13 |

| | |
|---|---|
| MASK FIRST AND SECOND EVALUATION REGIONS | S14 |

| | |
|---|---|
| DEPOSIT SILICON LAYER Sn−5 [nm] THICK | S15 |

**NO** (right branch):

| | |
|---|---|
| DEPOSIT SILICON LAYER Sn [nm] THICK | S16 |

| | |
|---|---|
| MASK EFFECTIVE REGION AND SECOND AND THIRD EVALUATION REGIONS | S17 |

| | |
|---|---|
| DEPOSIT SILICON LAYER 5−Sn [nm] THICK | S18 |

REPEAT 40 TIMES

| | |
|---|---|
| n = n + 1 | S20 |

S19 — n ≥ 60?

NO (loop back)

YES

TAKING OUT, FILM THICKNESS INSPECTION PROCESS

# FIG. 6A

# FIG. 6B

# FIG. 7

```
                    ┌─────────────┐
                    │   START     │
                    └──────┬──────┘
                           │
                           ▼                        S21
              ╱────────────────────────────╲
             ╱      WHICH                    ╲
            ╱   REGIONS ARE TO BE             ╲
            ╲       MASKED?                   ╱
             ╲                              ╱
              ╲────────────────────────────╱
         S22              S23                    S24
   ┌──────────────┐  ┌──────────────┐  ┌──────────────┐
   │ MASK SECOND  │  │ MASK FIRST   │  │ MASK FIRST   │
   │ AND THIRD    │  │ AND THIRD    │  │ AND SECOND   │
   │ EVALUATION   │  │ EVALUATION   │  │ EVALUATION   │
   │ REGIONS      │  │ REGIONS      │  │ REGIONS      │
   └──────────────┘  └──────────────┘  └──────────────┘
                           │                   S25
              Mo  ╱─────────────────╲  Si
                 ╱    Mo OR Si?      ╲
                 ╲                   ╱
                  ╲─────────────────╱
          S26                                S27
   ┌──────────────────┐            ┌──────────────────┐
   │ DEPOSIT Mo LAYER │            │ DEPOSIT Si LAYER │
   └──────────────────┘            └──────────────────┘
                           │                   S28
             NO   ╱─────────────────╲
                 ╱   COMPLETED?      ╲
                 ╲                   ╱
                  ╲─────────────────╱
                           │ YES
                    ┌──────▼──────┐
                    │    END      │
                    └─────────────┘
```

## FIG. 8A

## FIG. 8B

# FIG. 9A

# FIG. 9B

## FIG. 10A

## FIG. 10B

# FIG. 11A
# PRIOR ART

# FIG. 11B
# PRIOR ART

FIG. 12
PRIOR ART

FILM THICKNESS DISTRIBUTION

## FIG. 13A
## PRIOR ART

## FIG. 13B
## PRIOR ART

# FIG. 14

STEP S01

| CIRCUIT DESIGN |
|---|

STEP S03

| WAFER FABRICATION |
|---|

STEP S02

| MASK MAKING |
|---|

STEP S04

| WAFER PROCESS (FRONT-END PROCESS) |
|---|

STEP S05

| ASSEMBLY (BACK-END PROCESS) |
|---|

STEP S06

| INSPECTION |
|---|

STEP S07

| SHIPPING |
|---|

# FIG. 15

STEP S011

OXIDATION

STEP S012

CVD

STEP S013

ELECTRODE
FORMATION

STEP S014

ION IMPLANTATION

STEP S015

RESIST PROCESS

STEP S016

EXPOSURE

STEP S017

DEVELOPMENT

STEP S018

ETCHING

STEP S019

RESIST STRIPPING

REPEAT

**EP 2 068 326 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007134464 A
- US 20070171327 A1
- US 20050270648 A1